# EUROPÄISCHE PATENTANMELDUNG

(11) **EP 2 743 974 A1**
(43) Veröffentlichungstag der Anmeldung: **18.06.2014**
(21) Anmeldenummer: 13005526.2
(22) Anmeldetag: 27.11.2013
(51) Int. Cl.: H01L 21/67, H01S 3/04

(54) **Dämpfer, Kühlkreislauf und Apparatur für eine schwingungsempfindliche Substratbehandlungsapparatur**

(30) Priorität: 11.12.2012 DE 102012112064
(71) Anmelder: Von Ardenne GmbH, 01324 Dresden (DE)
(72) Erfinder: Hentschel, Michael, 01189 Dresden (DE)

(57) **Zusammenfassung**

Die Erfindung betrifft sowohl Dämpfer und Kühlkreislauf als auch die Apparatur selbst für eine schwingungsempfindliche Substratbehandlungsapparatur. Es steht die Aufgabe, kritische Schwingungen, die ursächlich von der Kühlung einer Apparatur herrühren, zu unterdrücken.

Die Lösung zeigt einen Dämpfer (8) zur Schwingungsreduzierung in einer Kühlmittelleitung (11), wobei die Kühlmittelleitung (11) zumindest anteilig durch eine Apparatur (1) verlaufend angelegt ist,
wobei die Apparatur (1) zur Behandlung eines Substrates (2) mittels eines von einer Lichtquelle (4) erzeugten hochfokussierten Lichtstriches (3) bei fortlaufender Bewegung des Substrates (2) relativ zum
Lichtstrich (3) in Transportrichtung (14) vorgesehen ist,
wobei der Dämpfer (8) mindestens zwei jeweils an Eingang (9) und Ausgang (10) mit der Kühlmittelleitung (11) verbundene Dämpferleitungen (12) aufweist, die derart ungleich in ihrer Dimension, Länge und/oder Querschnitt betreffend, ausgelegt sind, dass in den Dämpferleitungen (12) eine Phasenverschiebung der Schwingung erfolgt und sich am Ausgang (10) ein Interferenzeffekt einstellt, sodass der Dämpfer (8) die Amplitude der Schwingung der Kühlmittelleitung (11) und/oder des Kühlmittels am Eingang (9) gegenüber der am Ausgang (10) reduziert; Fig. 1.

## Beschreibung

Die Erfindung betrifft sowohl Dämpfer und Kühlkreislauf als auch die Apparatur selbst für eine schwingungsempfindliche Substratbehandlungsapparatur.
Die Apparatur ist aufgrund derer Wirkungsweise insofern schwingungsempfindlich, dass sich bei Schwingungen oder Stößen die substratbehandelnde Wirkung verzerrt, verfälscht oder zumindest unpräzise am Substrat niederschlägt. Derartige Probleme treten beispielsweise dort auf und lassen sich durch die Erfindung beheben, wo die Substratbehandlung mit fokussiertem Licht erfolgt.

Das Anwendungsgebiet der Erfindung betrifft die Behandlung großflächiger vorrangig flacher Substrate wie Glasscheiben, Kunststofffolien und Metallbänder, die im Zuge ihrer Behandlung eine Beschichtung erfahren. So lassen sich Beschichtungen für Architekturgläser und Photovoltaik sowie solche mit hochgradiger Reflexion oder Absorption schaffen. Vorstehendes erfolgt üblicherweise mittels Anlagen zur Vakuumbehandlung. Die die Erfindung betreffende Apparatur kommt derzeit vorrangig nachfolgend der Vakuumbehandlung zum Einsatz und das unter Normalbedingungen an Luft.

Aus DE 10 2006 047 472 A1 ist beispielhaft eine solche Behandlung mit kurzwelliger elektromagnetischer Strahlung bekannt, die auf großflächige Substrate angewandt wird.

Es handelt sich bei der Substratbehandlung mit fokussiertem bzw. hochfokussiertem Licht im Detail um eine solche, die vormaliges RTP (rapid thermal processing) insofern verbessert, dass diese Behandlung nicht mittels infraroter Strahlung sondern mit hochfokussiertem Licht wie optisch gebündeltem Laserlicht oder Blitzlampen durchgeführt wird, was eine vorteilhafte Form der Substratbehandlung möglich macht. Das Licht wirkt mit hoher Energiedichte jedoch mit kurzer Verweildauer auf das Substrat ein, sodass die thermische Wirkung nahe der äußersten Schicht auf dem Substrat verbleibt. Die erzielbaren Effekte lassen deutliche Vorzüge in der Gestaltung von Schichteigenschaften erkennen, da sich Nebenwirkungen durch Substraterwärmung wie beispielsweise Diffusion vermindert auswirken.

Ein diodengepumpten Festkörperlaser mit einer verbesserten Kühlung wird in DE 195 15 704 A1 gezeigt. Es handelt sich um eine vergleichsweise geringe Anzahl von Hochleistungslasern und um Laserdiodenarrays, ohne dass dazu nähere Verwendungsmöglichkeiten aufgezeigt werden. Es geht lösungsbezüglich um eine thermische Stabilisierung des Lasers, wobei es die thermisch bedingte Drift der Leistung des Lasers zu vermeiden gilt.

Problemursächlich kommen zwei noch im Detail ausgeführte wesentliche Aspekte in Betracht. Erstens sollen neuerlich besagte Apparaturen zur großflächigen Substratbehandlung eingesetzt werden, die jedoch empfindlich gegen jedwede Schwingungen sind. Zum Zweiten benötigen Apparaturen für die Substratbehandlung mit hochfokussiertem Licht leistungsfähige Kühlsysteme, wofür sich solche, deren Kühlmittelkreislauf oder -läufe sowie deren Kühlmittelleitungen mit einem Fluid gefüllt sind, anbieten. Übliche Kühlsysteme im besagten Anwendungsgebiet verwenden Kühlsysteme mit Wasser als Kühlmittel. Eine Besonderheit solcher Kühlsysteme liegt in der ausfallsicheren Arbeitsweise, wozu in der WO 2013/037423 A1 eine Lösung aufzeigt ist.

Das Problem bezüglich der Kühlung besteht nunmehr darin, dass durch die benötigten Pumpen Störschwingungen generiert werden, die sowohl über die Kühlleitung selbst als auch über das Kühlmittel an eine besagte Apparatur übertragbar sind und dann dort zumindest indirekt als kritische Schwingungen in Erscheinung treten.
Je nach Drehzahl der Pumpen gehen zunächst Störschwingungen mit eben solchen Frequenzen von den Pumpen selbst aus. Beispielsweise verursachen Kreiselpumpen, die mit bis zu 1000 U/min und darüber hinaus drehen, Störschwingungen von in etwa 10 bis 100Hz. Von Störschwingungen ausgehend können bis hin zum Auftreten von kritischen Schwingungen an der Apparatur Effekte der Dämpfung, der Eigenschwingungen des Kühlsystems und die verschiedener Schwingungsleitfähigkeit auftreten, sodass sich letztlich ein Spektrum mit mehr oder minder dominanten insbesondere an der Kühlmittelleitung nachweisbaren Schwingungen einstellen kann.

Kritische Schwingungen sind solche, dass ausgehend von einer fokussierten Lichtquelle jedweder Art und einschließlich Laser der von der Quelle ausgesandte Strahl am auftreffenden Ziel, dem Substrat, eine oszillierende Bewegung beschreibt. Diese Bewegung ist bereits kritisch, wenn sie Bruchteile von Mikro-, Milli- oder Sekunden andauert und auch dann, wenn die vollzogene Bewegung des Strahles auf dem Substrat, hier Amplitude, über wenige Mikrometer erfolgt. Zusammengenommen trifft damit der vormals an der Quelle fokussierte Strahl aufgrund der Schwingungen im zeitlichen Verlauf defokussiert am Substrat auf, was seine Wirkung bezüglich eines Energieeintrages auf die substratäußerste Fläche inhomogen macht. Als inhomogen ist bei solchen Energiedichten bereits eine Abweichung von 1 % und weniger pro Flächeneinheit einzustufen. Mit substratäußerster Fläche ist die Außenfläche des Substrates, hier Substrataußenfläche, gemeint, was die Oberfläche des Festkörpers, der das Substrat umfasst oder einschließt, ist; ohne beziehungsweise mit auf dem Substrat aufgetragenen Schichten. Bei der zu behandelnden Substrataußenfläche ist hier von der Behandlungsfläche die Rede.

Solches ist bei Apparaturen der Fall, wo sich Quelle und Substrat im Abstand zwischen ca. 2cm und 30cm zueinander befinden. Weiterhin betrifft dieser Effekt nicht primär den punktförmig auftreffenden Stahl sondern vielmehr so genannte Linienlichtquellen, die hochfokussiert dafür vorgesehen sind, einen linienförmigen Abschnitt eines Substrates zu behandeln, was hier als Lichtstrich bezeichnet wird.

In DE 10 2007 052 782 A1 ist ein Verfahren zur Substratbehandlung mittels Laserlicht, das eine linienförmige Intensitätsverteilung auf dem Substrat ausbildet, beschrieben. Vorgesehen ist die Behandlung einer TCO-Schicht, um insbesondere deren elektrische und/oder optische Eigenschaften zu verbessern.
Dieser Lichtstrich nach hiesiger Definition ist mit einer Breite zwischen 10µm und 100µm sowie mit einer Länge bis zu 3,30m vorgesehen. Energiedichten, die zwischen 1KW/cm² und 1000KW/cm² liegen können, sind dazu vorgeschlagen.

Im gattungsgemäßen Umfeld der Erfindung, kommt die vorstehend beschriebene Lösung in Betracht als auch weitere, bei denen von einer Lichtquelle aus, das Licht hochfokussierte, d.h. mit einer wie beschrieben hohen Energiedichte angewandt wird, und bei denen sich die Lichtquelle im beschriebenen Abstand zum Substrat befindet. Dann nämlich wirken sich besagte kritische Schwingungen nachteilig auf das Ergebnis der Substratbehandlung aus.

Den vorstehenden problematischen Bedingungen kommt hinzu, dass das Substrat kontinuierlich vorbei an der behandelnden Quelle und damit relativ zu dieser bewegt wird, um quasi den behandelnden Lichtstrich über das Substrat zu ziehen.
Die Quelle ist üblicherweise derart feststehend positioniert, dass der Lichtstrich quer über das Substrat verläuft, wobei das Substrat auf einem Transportpfad in Transportrichtung bewegt wird.
Zurück kommend auf die kritischen Schwingungen sind diese weniger kritisch, wenn sich dadurch der Lichtstrich ausschließlich quer zur Transportrichtung des Substrats bewegt. In allen übrigen Fällen kommt es jedoch zu besagten Abweichungen bezüglich der Homogenität des Energieeintrages pro Flächeneinheit; hier Flächenhomogenität. Anders gesagt, kann der Energieeintrag vorrangig in Transportrichtung derart schwingen, dass sich in Anbetracht des kontinuierlichen Substrattransports auf dem Substrat betrachtet in Transportrichtung eine unzureichende Flächenhomogenität zu verzeichnen ist. Dem scheint derzeit nur durch geeignete Mittel der Schwingungsdämpfung etwas entgegen zu setzen sein.

Aus dem Stand der Technik sind im Bereich der Anlagentechnik für die Substratbehandlung schwingungsdämpfende Mittel für Kühlleitungen, Kühlkreisläufe und Dergleichen zunächst nicht bekannt.

Die Erfindung macht es sich zur Aufgabe, besagte kritische Schwingungen, die ursächlich von der Kühlung einer Apparatur herrühren, weitestgehend so zu unterdrücken, dass in der Apparatur die Lichtquelle für hochfokussiertes Linienlicht frei von störenden Schwingungen betreibbar ist. Es ist eine Lösung zu finden, die die bislang bekannten Probleme überwindet.

Diese Aufgabe löst die Erfindung mit Dämpfung, Kühlkreislauf oder Apparatur gemäß Patentanspruch 1, 8 beziehungsweise 10. Vorteilhafte Ausgestaltungsformen der Erfindung zeigen Unteransprüche auf.

Der maßgebliche Vorteil der Erfindung ist gerade der, dass es gelingt, störende Schwingungen mit vergleichsweise einfachen Mittel zu dämpfen.

Die Lösung besteht in einem Dämpfer zur Schwingungsreduzierung, der angeordnet ist in einer Kühlmittelleitung, wobei die Kühlmittelleitung zumindest anteilig durch eine Apparatur verlaufend angelegt ist. Die Apparatur ist zur Behandlung eines Substrates mittels eines von einer Lichtquelle erzeugten hochfokussierten Lichtstriches vorgesehen und ausgestaltet, wobei die Behandlung bei fortlaufender Bewegung des Substrates relativ zum Lichtstrich in Transportrichtung erfolgt. Der Dämpfer weist mindestens zwei jeweils an Eingang und Ausgang mit der Kühlmittelleitung verbundene Dämpferleitungen auf, die derart ungleich in ihrer Dimension, Länge und/oder Querschnitt betreffend, ausgelegt sind, dass in den Dämpferleitungen eine Phasenverschiebung der Schwingung erfolgt und sich am Ausgang ein Interferenzeffekt einstellt.
Im Ergebnis ist davon auszugehen, dass durch den Dämpfer die Amplitude der Schwingung der Kühlmittelleitung und/oder des Kühlmittels am Eingang gegenüber der am Ausgang reduziert wird.

In weiterer Ausgestaltung des Dämpfers ist in einer Dämpferleitung ein weiterer Dämpfer angeordnet.

In weiterer Ausgestaltung des Dämpfers ist die Phasenverschiebung mit 180° vorgegeben.

In weiterer Ausgestaltung des Dämpfers ist mindestens eine Dämpferleitung (12) flexibel ausgeführt.

In weiterer Ausgestaltung des Dämpfers sind die Dämpferleitungen in der Länge derart unterschiedlich ausgeführt, dass der Interferenzeffekt für eine vorgegebene Störschwingung eintritt.

In weiterer Ausgestaltung des Dämpfers ist die Störschwingung durch eine an der Kühlleitung auftretende Schwingung vorgegeben.

In weiterer Ausgestaltung des Dämpfers ist die Störschwingung durch eine in der Kühlleitung im Kühlmittel auftretende Schwingung vorgegeben.

Eine weitere Ausführungsform der Erfindung stellt ein Kühlkreislauf einer Apparatur dar, wobei die Apparatur zur Behandlung eines Substrates mittels eines von einer Lichtquelle erzeugten hochfokussierten Lichtstriches bei fortlaufender Bewegung des Substrates relativ zum Lichtstrich in Transportrichtung vorgesehen und ausgestaltet ist. Der Kühlkreislauf weist einen Lichtquellenkühler zum Kühlen der Lichtquelle und mindestens eine den Lichtquellenkühler mit einer Pumpe verbindende Kühlmittelleitung auf. In der Kühlmittelleitung ist der erfindungsgemäße Dämpfer (gemäß einem der Ansprüche 1 bis 7) vorgesehen.

In weiterer Ausgestaltung des Kühlkreislaufes ist die Quelle mindestens einer Störschwingung die Pumpe.

Eine weitere Ausführungsform der Erfindung ist die Apparatur zur Behandlung eines Substrates mittels eines von einer Lichtquelle erzeugten hochfokussierten Lichtstriches bei fortlaufender Bewegung des Substrates relativ zum Lichtstrich in Transportrichtung, wobei diese den vorstehen genannten Kühlkreislauf (gemäß einem der Ansprüche 8 bis 9) aufweist.

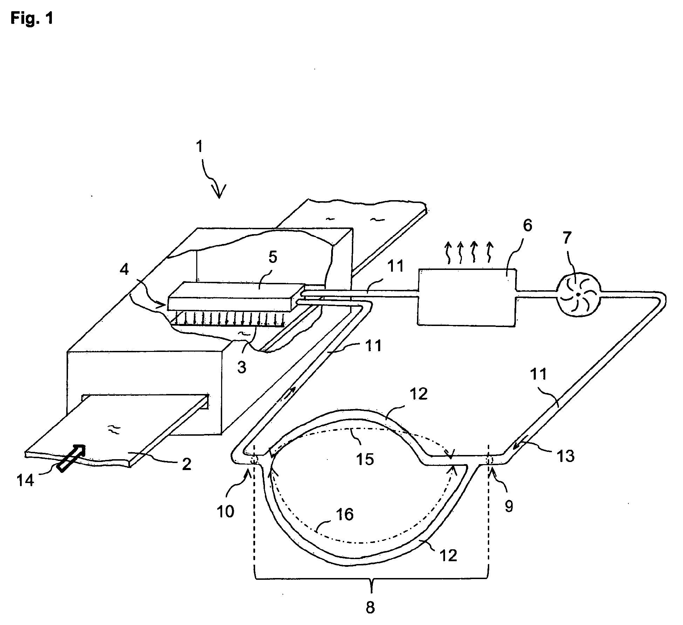

Nachfolgend soll die Erfindung anhand eines Ausführungsbeispiels näher beschrieben werden. Dazu zeigt die Fig. 1 die Apparatur 1, die beispielsweise so in den Transportpfad einer Vakuumbeschichtungsanlage integriert sein könnte, dass dort, wo die Substrate 2 die Anlage in Transportrichtung 14 verlassen, die Apparatur 1 aufgestellt wäre. Das Substrat 2 wird unter der Lichtquelle 4 an dieser vorbei bewegt. Dabei trifft auf die zu behandelnde Fläche des Substrats der Lichtstrich 3 auf. Bei einer solchen Lichtquelle 4 ist eine Lichtquellenkühlung 5 zwingend erforderlich. Lichtquelle 4 und Lichtquellenkühlung 5 stehen aus Gründen der Wärmeleitung zumindest in einem solchen mechanischen Kontakt zueinander, dass sich ein oder mehrere Schwingungen der Lichtquellenkühlung 5 auf die Lichtquelle 4 übertragen müssen.

Die Lichtquellenkühlung 5 ist in einen Kühlkreislauf eingebunden, der zunächst einen Wärmetauscher 6 eine Pumpe 7 und verbindenden Kühlmittelleitungen 11 vorsieht. Üblich ist die Verwendung von flüssigen Kühlmitteln zum Wärmetransport, wobei auch Gase und Kühlmittel mit wechselnden Aggregatzuständen denkbar sind. Mit einem Pfeil soll hier die Kühlmittelflussrichtung 13 angedeutet sein. Beispielsweise wird die Kühlmittelleitung 11 als festes Leitungsrohr sein und die Pumpe 7 als Kreiselpumpe ausgeführt sein.

Der erfindungswesentliche Dämpfer 8 ist so in die Kühlmittelleitung 11 integriert, dass dieser vom Eingang 9 bis zum Ausgang 10 vom Kühlmittel durchflossen wird. Gerade am Eingang 9 und Ausgang 10 ist es möglich, so genannte Volumenstromsteiler einzusetzen, um die Querschnitte der Dämpferleitungen 12 so zu dimensionieren, dass die unterschiedliche Ausbreitung der diskreten Schwing in den Dämpferleitungen 12 zu einer Phasenverschiebung und zur gewollten Interferenz führt. Gezeigt ist mit der ersten Länge 15 und der zweiten Länge 16, die alternative Ausführung, in der die Dämpferleitungen 12 unterschiedlich lang sind. Mit flexiblen Dämpferleitungen 12 lässt sich vorteilhafterweise die Schwingungsübertragung zwischen Eingang 9 und Ausgang 10 von bzw. auf die jeweilige Kühlmittelleitung 11 vermindern.

Da nicht zwingend eine signifikant störende Schwingung sondern eher ein Spektrum solcher Schwingung an den Leitungen und primär an Lichtquelle 4 oder Lichtquellenkühlung 5 vorzufinden sein wird, gilt es, dieses in erster Näherung zu ermitteln und den Dämpfer 8 demensprechend und bestenfalls kaskadiert - Dämpfer in Dämpfer - zu dimensionieren.

Der Dämpfer 8 ist vorteilhafterweise in mindestens zweifacher Ausfertigung im Kühlkreislauf bezüglich der Kühlmittelflussrichtung 13 einmal vor und einmal nach der Lichtquellenkühlung 5 in der Kühlmittelleitung 11 vorzusehen. So ist die Lichtquellenkühlung 5 an den zwei Kühlmittelleitungen 11, die diese mit dem übrigen Kühlkreislauf verbinden, mit diesem schwingungsentkoppelt verbunden.

Vorteilhaft ist zudem die Verwendung eines Dämpfers 8 in einer Kühlmittelleitung 11 zur Schwingungsreduzierung für eine Apparatur 1, die zur Behandlung eines Substrates 2 mittels eines von einer Lichtquelle 4 erzeugten hochfokussierten Lichtstriches 3 bei fortlaufender Bewegung des Substrates 2 relativ zum Lichtstrich 3 in Transportrichtung 14 vorgesehen ist,
wobei der Dämpfers 8 mindestens zwei jeweils an Eingang 9 und Ausgang 10 mit der Kühlmittelleitung 11 verbundene Dämpferleitungen 12 aufweist, die derart ungleich in ihrer Dimension, Länge und/oder Querschnitt betreffend, ausgelegt sind, dass in den Dämpferleitungen 12 eine Phasenverschiebung der Schwingung erfolgt und sich am Ausgang 10 ein Interferenzeffekt einstellt.

Eine äquivalente Nutzung der Erfindung wird darin gesehen, das insgesamt Vorstehende anstatt für eine Kühlung für eine Heizung einzusetzen.

### Bezugszeichenliste

- 1: Apparatur
- 2: Substrat
- 3: Lichtstrich
- 4: Lichtquelle
- 5: Lichtquellenkühler
- 6: Wärmetauscher
- 7: Pumpe
- 8: Dämpfer
- 9: Eingang
- 10: Ausgang
- 11: Kühlmittelleitung
- 12: Dämpferleitung
- 13: Kühlmittelflussrichtung
- 14: Transportrichtung
- 15: erste Länge
- 16: zweite Länge

## Patentansprüche

1. Dämpfer (8) zur Schwingungsreduzierung angeordnet in einer Kühlmittelleitung (11), wobei die Kühlmittelleitung (11) zumindest anteilig durch eine Apparatur (1) verlaufend angelegt ist,
wobei die Apparatur (1) zur Behandlung eines Substrates (2) mittels eines von einer Lichtquelle (4) erzeugten hochfokussierten Lichtstriches (3) bei fortlaufender Bewegung des Substrates (2) relativ zum Lichtstrich (3) in Transportrichtung (14) vorgesehen ist,
wobei der Dämpfer (8) mindestens zwei jeweils an Eingang (9) und Ausgang (10) mit der Kühlmittelleitung (11) verbundene Dämpferleitungen (12) aufweist, die derart ungleich in ihrer Dimension, Länge und/oder Querschnitt betreffend, ausgelegt sind, dass in den Dämpferleitungen (12) eine Phasenverschiebung der Schwingung erfolgt und sich am Ausgang (10) ein Interferenzeffekt einstellt,
sodass der Dämpfer (8) die Amplitude der Schwingung der Kühlmittelleitung (11) und/oder des Kühlmittels am Eingang (9) gegenüber der am Ausgang (10) reduziert.

2. Dämpfer nach Anspruch 1, **dadurch gekennzeichnet, dass** in einer Dämpferleitung (12) ein weiterer Dämpfer angeordnet ist.

3. Dämpfer nach Anspruch 1 oder 2, **dadurch gekennzeichnet, dass** die Phasenverschiebung mit 180° vorgegeben ist.

4. Dämpfer nach einem der Ansprüche 1 bis 3, **dadurch gekennzeichnet, dass** mindestens eine Dämpferleitung (12) flexibel ausgeführt ist.

5. Dämpfer nach einem der Ansprüche 1 bis 4, **dadurch gekennzeichnet, dass** die Dämpferleitungen (12) in der Länge (15, 16) derart unterschiedlich ausgeführt sind, dass der Interferenzeffekt für eine vorgegebene Störschwingung eintritt.

6. Dämpfer nach Anspruch 5, **dadurch gekennzeichnet, dass** die Störschwingung durch eine an der Kühlleitung (11) auftretende Schwingung vorgegeben ist.

7. Dämpfer nach Anspruch 5 oder 6, **dadurch gekennzeichnet, dass** die Störschwingung durch eine in der Kühlleitung (11) im Kühlmittel auftretende Schwingung vorgegeben ist.

8. Kühlkreislauf einer Apparatur (1), die zur Behandlung eines Substrates (2) mittels eines von einer Lichtquelle (4) erzeugten hochfokussierten Lichtstriches (3) bei fortlaufender Bewegung des Substrates (2) relativ zum Lichtstrich (3) in Transportrichtung (14) vorgesehen ist,
der einen Lichtquellenkühler (5) zum Kühlen der Lichtquelle (4) und
mindestens eine den Lichtquellenkühler (5) mit einer Pumpe (7) verbindende Kühlmittelleitung (11) aufweist,
**dadurch gekennzeichnet, dass** in der Kühlmittelleitung (11) ein Dämpfer (8) gemäß einem der vorhergehenden Ansprüche vorgesehen ist.

9. Kühlkreislauf nach Anspruch 5, **dadurch gekennzeichnet, dass** die Quelle mindestens einer Störschwingung die Pumpe (7) ist.

10. Apparatur (1) zur Behandlung eines Substrates (2) mittels eines von einer Lichtquelle (4) erzeugten hochfokussierten Lichtstriches (3) bei fortlaufender Bewegung des Substrates (2) relativ zum Lichtstrich (3) in Transportrichtung (14) aufweisend einen Kühlkreislauf gemäß einem der Ansprüche 8 bis 9.
